# EUROPEAN PATENT APPLICATION

(11) **EP 1 986 248 A2**
(43) Date of publication of application: **29.10.2008**
(21) Application number: 08154846.3
(22) Date of filing: 21.04.2008
(51) Int. Cl.: H01L 51/52

(54) **Method of manufacturing an organic device**

(30) Priority: 23.04.2007 JP 2007113052
(71) Applicant: KABUSHIKI KAISHA TOYOTA JIDOSHOKKI, Kariya-shi, Aichi-ken 448-8671 (JP)
(72) Inventor: HOSHI, Sakutaro, Kariya-shi Aichi 448-8671 (JP); KAWAUCHI, Hiroyasu, Kariya-shi Aichi 448-8671 (JP); NIIDA, Eiki, Kariya-shi Aichi 448-8671 (JP); HARADA, Masayuki, Kariya-shi Aichi 448-8671 (JP); SAITO, Yasushi, Kariya-shi Aichi 448-8671 (JP); TSUTSUI, Yusuke, Kariya-shi Aichi 448-8671 (JP)
(74) Representative: TBK-Patent

(57) **Abstract**

A method of manufacturing an organic device includes the following steps. The first step is a step of forming a plurality of organic elements in the form of a matrix on a brittle substrate. Each of the organic elements is provided with an electrically connecting portion which electrically connects the organic element to an external circuit. The second step is a step of forming a sealing film on each organic element by a wet process with at least a part of the connecting portion covered with an adhesive masking material. The third step is a step of removing an adhesive deposit after peeling off the adhesive masking material. The fourth step is a step of forming a plurality of scribe lines on the brittle substrate. The fifth step is a step of breaking the brittle substrate along the scribe lines.

## Description

### BACKGROUND OF THE INVENTION

The present invention relates to a method of manufacturing an organic device.

An organic electroluminescence element degrades by moisture or oxygen in the atmosphere. To protect such an element against the degradation, a sealing can or sealing film is used for covering the element. In the case of covering the element with the sealing film, a method such as a CVD (chemical vapor deposition), a sputtering, a dip coating or a spray coating is taken. Any one or a combination of inorganic film and organic film is used for the sealing film. The combination includes a composite structure of the inorganic film and the organic film, and a laminated structure thereof.

Because the organic electroluminescence element is driven by electric power, the element is provided with electrically connecting portions which electrically connect the element to an external circuit. When the sealing film is applied to the element, the connecting portions may also be sealed thereby insulating the element electrically. To avoid the insulation of the element, the connecting portions should be covered with a shadow mask, a masking tape or the like for preventing the connecting portions from being sealed in forming the sealing film on the element.

The organic electroluminescence element is manufactured through the following steps. At first, a plurality of organic electroluminescence elements are formed in the form of a matrix on a large-size brittle substrate and covered with the sealing can or sealing film. Then, a plurality of scribe lines are formed on the brittle substrate by a scribe device. When the large-size brittle substrate is broken into plural parts by applying forces to the brittle substrate along the scribe lines, a plurality of individual electroluminescence elements are manufactured.

Japanese Unexamined Patent Application Publication No. 2002-151254 discloses a method of manufacturing an organic electroluminescence element. In the method, a pair of electrodes and an organic layer are covered with a protective film and an electrically connecting portion is uncovered. The method proposes uncovering the connecting portion appropriately without a process for forming the protective film with a metal mask or a wet process. To be more specific, the method includes a step of forming a laminated body on a substrate by laminating an anode, an organic layer and a cathode. The organic layer includes a light emitting layer and is made of an organic light-emitting material. At least one of the anode and the cathode is provided with an electrically connecting portion which is electrically connected with an external circuit. The method includes another step of applying a masking tape to the connecting portion. The method includes a further step of forming the protective film on the laminated body for covering and protecting the laminated body. The method includes a still further step of exposing the connecting portion by removing the protective film together with the masking tape from the connecting portion.

According to the method of the above Publication, the masking tape is applied to the connecting portion without using the metal mask and the protective film (or sealing film) is formed on the laminated body. Then, the connecting portion is uncovered (or exposed) by removing the protective film together with the masking tape from the connecting portion. However, if the sealing film is formed by a dry process with the connecting portion covered with the masking tape, the sealing film is easily broken at its end or cracked in peeling off the masking tape. The dry process is a process for forming a thin film under a vacuum state or reduced pressure, and includes a vacuum deposition process or a CVD process.

Alternatively, if the sealing film is formed by a wet process with the connecting portion covered with the masking tape, there remain adhesive deposits in peeling off the masking tape. These adhesive deposits are compounds formed by reacting material of the sealing film with adhesive of the masking tape. The adhesive deposits are located at a boundary between the masking tape which had been applied to the connecting portion and the sealing film. When the organic electroluminescence elements are formed in the form of a matrix on one large-size brittle substrate, such adhesive deposits are formed in the line shape on the large-size brittle substrate so as to run the large-size brittle substrate crosswise or lengthwise. On the other hand, the organic electroluminescence elements in the form of a matrix need to be separated into individual organic electroluminescence elements. In order to separate the organic electroluminescence elements in the form of a matrix, scribe lines need to be formed on the large-size brittle substrate so as to run the large-size brittle substrate crosswise and lengthwise. If the scribe lines are formed on the surface of the large-size brittle substrate having the adhesive deposits, the scribe lines are intermissive in intersecting with the adhesive deposits. Thus, defective scribe occurs. In this case, a part of the large-size brittle substrate broken by the following break step is also defective and the product yield is decreased, accordingly. The break step is a process of breaking the large-size brittle substrate by applying forces to the large-size brittle substrate along the scribe lines.

If the scribe lines are formed on the surface opposite to the surface of the large-size brittle substrate having the adhesive deposits, the large-size brittle substrate is swelled due to the adhesive deposits. The swelled large-size brittle substrate causes the scribe lines to change in depth. In some cases, the scribe lines are intermissive directly above the adhesive deposits, so that the defective scribe occurs. In addition, soft adhesive deposits cause viscoelastic deformation in forming the scribe lines, thereby failing to hold the work. Therefore, the defective scribe occurs directly above the adhesive deposits of the large-size brittle substrate. A part of the substrate broken by the following break step is also defective and the product yield is decreased, accordingly.

Not only the organic electroluminescence element but also an organic element such as an organic transistor, an organic diode and the like is subject to an adverse effect by moisture or oxygen. Therefore, such an organic element is preferably sealed by the sealing film and has similar problems.

The present invention is directed to a method of manufacturing an organic device. An organic element is formed on a brittle substrate and provided with at least an electrically connecting portion which electrically connects the organic element to an external circuit. The organic element is sealed by a sealing film so as to exclude at least a part of the connecting portion. Even if a plurality of the organic elements are formed in the form of a matrix on the brittle substrate and the sealing film is formed by a wet process, occurrence of defective scribe in a scribe step is reduced. This improves product yield of the organic element.

### SUMMARY OF THE INVENTION

The present invention provides a method of manufacturing an organic device. The method includes the following steps. The first step is a step of forming a plurality of organic elements in the form of a matrix on a brittle substrate. Each of the organic elements is provided with an electrically connecting portion which electrically connects the organic element to an external circuit. The second step is a step of forming a sealing film on each organic element by a wet process with at least a part of the connecting portion covered with an adhesive masking material. The third step is a step of removing an adhesive deposit after peeling off the adhesive masking material. The fourth step is a step of forming a plurality of scribe lines on the brittle substrate. The fifth step is a step of breaking the brittle substrate along the scribe lines.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
Fig. 1A is a schematic plan view of an organic electroluminescence device according to one embodiment of the present invention;
Fig. 1B is a schematic sectional view of the organic electroluminescence device as seen from the line A-A of Fig. 1A;
Fig. 1C is a schematic sectional view of the organic electroluminescence device as seen from the line B-B of Fig. 1A;
Fig. 2 is a flow chart illustrating steps of a manufacturing method of the organic electroluminescence device;
Fig. 3A is a schematic sectional view of the organic electroluminescence device in the make and shows a position of application of a masking tape;
Fig. 3B is another schematic sectional view of the organic electroluminescence device in the make and shows the position of application of the masking tape;
Fig. 3C is a schematic plan view of the organic electroluminescence device from which a sealing film is omitted, and shows positions of adhesive deposits;
Fig. 4 is a schematic view of the organic electroluminescence device in which a scribe step of the steps is not performed; and
Fig. 5 is a schematic view of the organic electroluminescence device in which the scribe step is performed.

### DETAILED DESCRIPTION OF THE PREFERRED EMBODIMENTS

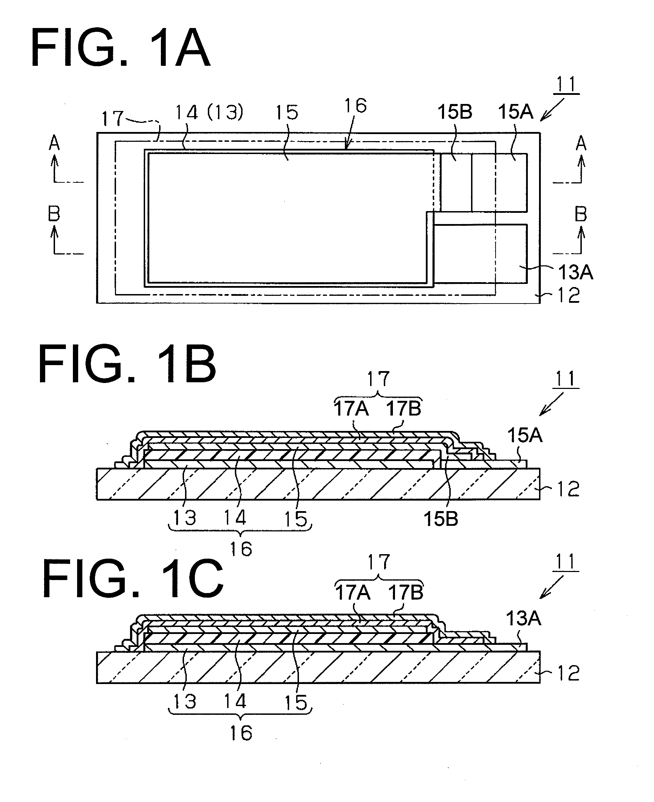

The following will describe a method of manufacturing an organic electroluminescence device according to one embodiment of the present invention with reference to Figs. 1A to 4. As shown in Figs. 1A to 1C, the organic electroluminescence device 11 includes a glass substrate 12, an organic electroluminescence element 16 and a sealing film 17. The organic electroluminescence device 11 serves as an organic device. The organic electroluminescence element 16 serves as an organic element. It is noted that the term "organic element" intends any element which is formed by using organic material and driven by electric power. The organic material includes an organic electroluminescence element, an organic transistor and an organic diode. The organic electroluminescence element 16 includes a first electrode 13, an organic electroluminescence layer 14 and a second electrode 15. The organic electroluminescence layer 14 serves as a light emitting layer. The first electrode 13, the organic electroluminescence layer 14 and the second electrode 15 are laminated on the glass substrate 12 in this order. The organic electroluminescence element 16 is sealed by the sealing film or protective film 17 so that the organic electroluminescence layer 14 is not subject to an adverse effect by moisture (water vapor) and oxygen. In the following description, the term "organic electroluminescence" is referred to as "organic EL".

Figs. 1A to 1C show the structure of the organic EL device 11 schematically. For the sake of convenience of illustration, some dimensions are exaggeratedly shown. Therefore, the ratios of the dimension such as length and thickness of the organic EL device 11 are different from actual those.

In the present embodiment, the first electrode 13 is an anode and the second electrode 15 is a cathode. The first electrode 13 is made of transparent material. It is noted that the term "transparency" intends to enable at least a visible light to be permeable. The first electrode 13 is made of indium tin oxide (ITO) which is used for a transparent electrode of a known organic EL element. The first electrode 13 is formed by a film of ITO. The second electrode 15 is made of metallic material such as aluminum and serves to reflect light. The organic EL element 16 is a bottom emission type and the light of the organic EL layer 14 is extracted (or emitted) through the glass substrate 12.

As shown in Fig. 1A, the horizontal projection of the organic EL element 16 forms a rectangle substantially. More specifically, the horizontal projection of the first electrode 13 forms a rectangle substantially. The same applies to the organic EL layer 14 and the second electrode 15. The rectangle of the first electrode 13 is larger in area than that of the organic EL layer 14. The rectangle of the second electrode 15 is smaller in area than that of the organic EL layer 14. The first electrode 13 is provided with a first electrically connecting portion 13A which electrically connects the first electrode 13 to an external circuit. The first connecting portion 13A is located adjacent to the first electrode 13 or on the right side of Fig. 1A. The first connecting portion 13A is made of the same material as that of the first electrode 13 and formed integrally with the first electrode 13.

The second electrode 15 is provided with a second electrically connecting portion 15A which electrically connects the second electrode 15 to the external circuit. The second connecting portion 15A is located adjacent to the second electrode 15 or on the right side of Fig. 1A. The second connecting portion 15A is made of the same material as those of the first electrode 13 and the first connecting portion 13A. The second electrode 15 has an extending portion 15B which is connected to the second connecting portion 15A.

The sealing film 17 is made of the material which serves to at least prevent moisture (water vapor) and oxygen from permeating. In the present embodiment, the sealing film 17 includes a first sealing film 17A and a second sealing film 17B thereby forming a two-layer structure. The first sealing film 17A is formed by a dry process and the second sealing film 17B is formed by a wet process. It is noted that the term "dry process" intends any process for forming a thin film under a vacuum state or reduced pressure. The method includes a vacuum deposition process, a sputtering process, an ion plating process, a process using ion beam and a CVD (chemical vapor deposition) process. It is also noted that the term "wet process" intends any process for applying a solution of material of a sealing film to something and then forming a solid sealing film by drying or reacting the solution. The first sealing film 17A is made of silicon nitride, for example. The second sealing film 17B is made of silicon dioxide, for example. Silica (silicon dioxide) is formed by inverting a coating film formed by polysilazane. The second sealing film 17B is formed so as to cover the first sealing film 17A.

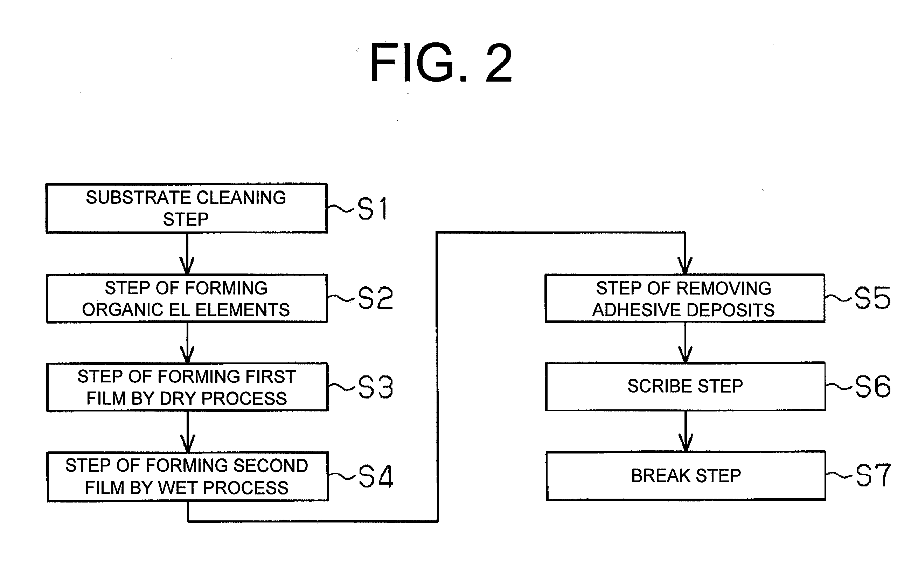

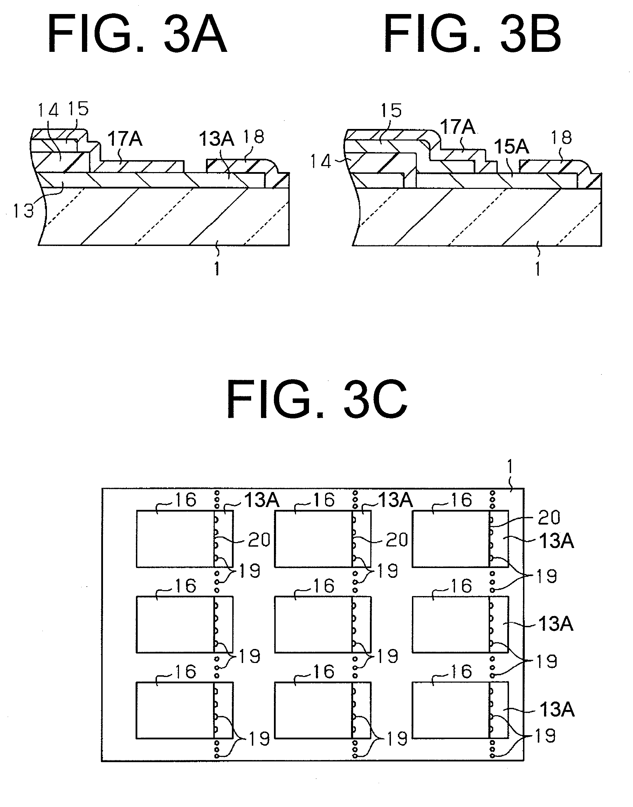

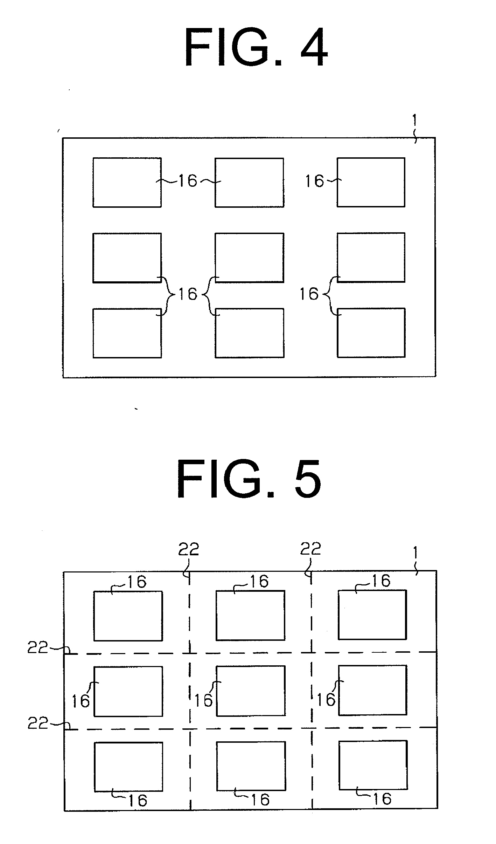

The following will describe a method of manufacturing the organic EL device 11 as structured above. Manufacturing the organic EL device 11 is performed by following the steps of the flow chart of Fig. 2. Before manufacturing the organic EL device 11, referring to Fig. 3A to 3C, a large-size glass substrate 1 that serves as a brittle substrate is prepared. In the substrate cleaning step S1, the large-size glass substrate 1 is cleaned. In the step S2 of forming the organic EL elements 16, as shown in Fig. 4, a plurality of organic EL elements 16 are formed in the form of a matrix on the large-size glass substrate 1. In the present invention, the step S2 serves as a step of forming organic elements. In the present embodiment, nine organic EL elements 16 are formed in the form of a 3 x 3 matrix on the large-size glass substrate 1.

In the step S2 of forming the organic EL elements 16, the first electrodes 13, the organic EL layers 14 and the second electrodes 15 are formed in this order. The first electrodes 13 are formed as follows. The film of ITO is formed on the large-size glass substrate 1 by a known thin film forming process. After resist pattern is formed in the film of ITO by a photolithography, etching is applied to the film of ITO thereby patterning the first electrodes 13. In this case, the first connecting portions 13A and the second connecting portions 15A are formed simultaneously with the first electrodes 13 at predetermined positions of the large-size glass substrate 1.

After the surface of ITO of the large-size glass substrate 1 or the surface of the large-size glass substrate 1 adjacent to the first electrodes 13 is cleaned by plasma ozone, the organic EL layers 14 are formed on the first electrodes 13. The organic EL layers 14 are formed by forming each constituent layer of the organic EL layers 14 one after another by a known vacuum deposition process. After the organic EL layers 14 are all formed, the second electrodes 15 are formed on the organic EL layers 14 by depositing Al, for example. In this case, the extending portions 15B are formed so as to connect with parts of the second connecting portions 15A, respectively. The organic EL elements 16 are formed through the above processes.

Then, the sealing films 17 are formed on the organic EL elements 16 so as to exclude at least a part of each connecting portion 13A and at least a part of each connecting portion 15A. In the present embodiment, the sealing films 17 are formed by two steps, one of which is the step S3 of forming the first sealing films 17A by the dry process and the other is the step S4 of forming the second sealing films 17B by the wet process. In the present invention, the step S3 serves as a step of forming a sealing film with a dry process and the step S4 serves as a step of forming a sealing film with a wet process. The step S4 is performed after the step S3.

In the dry process of S3, a film of silicon nitride is formed by a plasma CVD process using a shadow mask, thereby forming the first sealing films 17A. In the wet process of S4, the second sealing films 17B are formed by the wet process with at least a part of each connecting portion 13A and at least a part of each connecting portion 15A covered with an adhesive masking material, such as a masking tape 18. As shown in Fig. 3A, when the masking tape 18 is applied to the connecting portion13A, a part of the connecting portion 13A which is not covered with the first sealing film 17A is uncovered (or exposed). As shown in Fig. 3B, when the masking tape 18 is applied to the connecting portion 15A, a part of the connecting portion 15A which is not covered with the first sealing film 17A is uncovered (or exposed). The masking tape 18 is applied not only to the parts of the connecting portions 13A and 15A but also to the large-size glass substrate 1 so as to run the large-size glass substrate 1 lengthwise. With the masking tape 18 applied to the large-size glass substrate 1, a solution provided by dissolving polysilazane in a hydrophobic organic solvent such as xylene is applied by a spray coating. After forming the coating film, polysilazane is inverted to silica (silicon dioxide), thereby forming the second sealing films 17B.

After the masking tape 18 is peeled off, the step S5 of removing adhesive deposits 19 is performed. In the present invention, the step S5 serves as a step of removing an adhesive deposit. It is noted that the organic EL layer 14 and the second electrode 15 are generally less in thickness than 1 micrometer and the sealing film 17 is also less in thickness than a several micrometers. Therefore, the organic EL layer 14, the second electrode 15 and the sealing film 17 lack in shock resistance and are easily broken. To enhance the shock resistance of those, a protective coat may be applied to the sealing film 17.

When the masking tape 18 is peeled off, there remains a part of mixture of adhesive of the masking tape 18 and material of the sealing film 17 to form one or more adhesive deposits 19. As shown in Fig. 3C, these adhesive deposits 19 are formed at positions corresponding to boundaries 20 which were located between the masking tape 18 which had been applied to the large-size glass substrate 1 and the sealing film 17. To be more specific, the adhesive deposits 19 are a mixture of adhesive of the masking tape 18 and material (silicon compound) of the second sealing film 17B. The adhesive deposits 19 each has such a size as visibly confirmed and is produced mainly at the end of the masking area. Such adhesive deposits 19 may serve as minute foreign particles which are involved in the bonded area between the first connecting portion 13A and a flexible printed circuit. The flexible printed circuit is referred to as FPC hereinafter.

In the step S5 of removing the adhesive deposits, the adhesive deposits 19 are removed by polishing. Buffing is preferable for the polishing. In the scribe step S6, as shown in Fig. 5, a plurality of scribe lines 22 are formed on the large-size glass substrate 1 by a known scribe device. In the present embodiment, four scribe lines 22 are formed on the large-size glass substrate 1. Two of the scribe lines 22 run the large-size glass substrate 1 lengthwise and the rest of the scribe lines 22 run the large-size glass substrate 1 crosswise.

In the break step S7, the large-size glass substrate 1 is broken into nine glass substrates 12 along the scribe lines 22.

The following will describe one example of removal of the adhesive deposits 19 in detail. Suede cloth (Refine Tec Corporation: model number 52-108) is used for the buffing. Diamond paste (Refine Tec Corporation: model number 41-101, oiliness) and lapping oil (Refine Tec Corporation: model number 70-401) are used for abrasive material. The diamond paste is an oil binder containing diamond particle having a particle diameter of 1 micrometer. The lapping oil is a synthetic oil.

The polishing is performed by the following procedure.
1. Infiltrating the lapping oil into the suede cloth.
2. Adding the diamond paste to the front side of the suede cloth.
3. Holding against the reverse side of the suede cloth a plastic block whose shape is a square having a couple of centimeters on each side.
4. Rubbing the front side of the suede cloth against an appropriate glass plate so that the suede cloth absorbs the diamond paste.
5. Mounting the organic EL device 11 on a horizontal and hard glass plate with the connecting portions 13A, 15A of the organic EL device 11 up.
6. Rubbing the boundary 20 and the connecting portions 13A, 15A with the front side of the suede cloth which has absorbed the lapping oil and the diamond paste well.
7. Giving about ten strokes to the suede cloth so that stroke length of the suede cloth is about 0.02 meter and load applied to the boundary 20 and the connecting portions 13A, 15A is about 0.02 to 0.03 kilogram.
8. If the protective coat is being applied to the organic EL device 11, a rubbing direction is set perpendicular to a longitudinal direction of the organic EL device 11 so as not to peel off the protective coat.
9. After polishing operation, wiping the lapping liquid from the organic EL device 11 with waste. Then, cleaning the connecting portions 13A, 15A with waste into which ethyl alcohol is impregnated thereby to remove the oil component of the lapping liquid from the connecting portions 13A, 15A.

In the above procedure, the adhesive deposits 19 of the boundary 20 and dirt of the connecting portions 13A, 15A are removed.

If the adhesive deposits 19 are formed simply by a part of adhesive of the masking tape 18, the adhesive deposits 19 are removable by wiping with organic solvent. Because the adhesive deposits 19 contain the silicon compound, however, the adhesive deposits 19 are not removable by wiping with the organic solvent. If the scribe device forms the scribe lines 22 on the surface of the large-size glass substrate 1 having the adhesive deposits 19, the scribe lines 22 are intermissive in intersecting with the adhesive deposits 19. Thus, defective scribe occurs. If the scribe device forms the scribe lines 22 on the surface opposite to the surface of the large-size glass substrate 1 having the adhesive deposits 19, the large-size glass substrate 1 is swelled due to the adhesive deposits 19. The swelled large-size glass substrate 1 causes the scribe lines 22 to change in depth. In some cases, the scribe lines 22 are intermissive directly above the adhesive deposits 19, so that the defective scribe occurs. In addition, soft adhesive deposits 19 cause viscoelastic deformation in forming the scribe lines 22, thereby failing to hold the work. Therefore, the defective scribe occurs directly above the adhesive deposits 19 of the large-size glass substrate 1. A part of the substrate broken by the following break step S7 is also defective and the product yield is decreased, accordingly.

On the other hand, when the step S5 of removing the adhesive deposits 19 is provided in the manufacturing method of the organic EL device 11, the adhesive deposits 19 are removed well. When the scribe lines 22 are formed on the large-size glass substrate 1, occurrence of the defective scribe is reduced, which improves the product yield of the organic EL device 11. In the step S5, the surfaces of the connecting portions 13A and 15A are polished. This enables well connection between the connecting portions 13A, 15A and the FPC.

The above embodiment has the following advantageous effects.
(1) The manufacturing method of the organic EL device 11 includes the step S2, the step S4, the step S5, the scribe step S6 and the break step S7. The step S2 is a process of forming a plurality of organic EL elements 16 in the form of a matrix on the large-size glass substrate 1. The step S4 is a process of forming the second sealing films 17B by the wet process with at least a part of each connecting portion 13A and at least a part of each connecting portion 15A covered with the masking tape 18. The step S5 is a process of removing the adhesive deposits 19 after peeling off the masking tape 18. The scribe step S6 is a process of forming a plurality of scribe lines 22 on the large-size glass substrate 1. The break step S7 is a process of breaking the large-size glass substrate 1 into the nine glass substrates 12 along the scribe lines 22. In the present embodiment, the adhesive deposits 19, which are formed in peeling off the masking tape 18, are removed in the step S5. The adhesive deposits 19 are a mixture of adhesive of the masking tape 18 and material of the second sealing films 17B. For the above reason, in the scribe step S6, the occurrence of the defective scribe is reduced, which improves the product yield of the organic EL device 11.
(2) The wet process is performed after the dry process. Under the condition of the same film thickness, the film formed by the dry process is generally lower in moisture and oxygen permeability than that formed by the wet process. The film formed by the dry process includes a vapor deposition film and the film formed by the wet process includes a coating film. However, the film formed by the dry process tends to cause a minute defect such as pinhole originating on unevenness of the underlying layer or foreign substances. In the present embodiment, the film formed by the dry process is combined with the film formed by the wet process which is flexible enough to cover the minute defect thereby to enhance sealing function or sealing performance of the sealing film 17. In addition, the sealing film 17 is a composite film of the first sealing film 17A formed by the dry process and the second sealing film 17B formed by the wet process. This composite structure enhances the sealing function or sealing performance of the sealing film 17.
(3) The step S5 includes a process of polishing the connecting portions 13A and 15A in addition to the process of removing the adhesive deposits 19. This enables the surfaces of the connecting portions 13A and 15A to be connected with the FPC well even the composite structure of the sealing film 17.
(4) The polishing of the step S5 is performed by buffing. This buffing is performed by applying abrasive grain to a soft buff such as a suede cloth and pressing the buff against the surfaces of the connecting portions 13A and 15A. The connecting portions 13A and 15A serve as a polished portion. Comparing to a polishing such as shot blasting, wherein the abrasive grain is blasted by dry process, the adhesive deposits 19 are removed easily with a smaller polishing operation of the surfaces of the connecting portions 13A and 15A.

The present invention is not limited to the embodiment described above, but may be modified as exemplified below.

In the step S5, an aqueous diamond paste (41-101, aquosity) and an aqueous lapping liquid (70-501, aqueous liquid) may be used for the abrasive material. In this case, after the lapping liquid is wiped from the organic EL device 11 with waste, the connecting portions 13A, 15A may be further cleaned with waste into which pure water is impregnated.

The particle diameter of the abrasive grain for use in the buffing is not limited to 1 micrometer, but may be less or more than 1 micrometer.

The polishing of the step S5 is not limited to the buffing, but may be abrasive blasting. This abrasive blasting is spraying granular abrasive material with compressed air in the state where mask operation is provided to the organic EL device 11 except for the connecting portions 13A and 15A. The connecting portions 13A and 15A serve as the polished portion, and the abrasive material includes abrasive grain, iron grain, grain of glass and grain of sand. The polishing may be performed by spraying a mixture of the abrasive grain and a liquid on the surface of the polished portion with compressed air.

The polishing of the step S5 may not use the granular abrasive material such as the abrasive grain. In this case, the surfaces of the connecting portions 13A and 15A may be polished by whetstone, sandpaper or the like.

The first sealing film 17A formed by the dry process is not limited to the film of silicon nitride, but may be a film made of another inorganic material. This inorganic material includes a silicon-based compound such as silicon oxide, silicon oxynitride, silicon carbide and glass. The first sealing film 17A is not limited to the silicon-based compound, but may be an electrically insulating material such as metallic oxide and metallic nitride. The metallic oxide includes aluminum oxide and the metallic nitride includes aluminum nitride.

The first sealing film 17A formed by the dry process is not limited to a single-layer film, but may be a multi-layer film. The laminated films of the multi-layer film are not limited to those formed by the silicon-based compound or the electrically insulating material. The multi-layer film may be formed by laminating a metallic film on a film having electrically insulating properties. The metallic film includes aluminum film, silver film and copper film. The number of laminated films is not limited to two, but may be three or more. When the first sealing film 17A is formed by a single-layer or multi-layer metallic film, it is difficult to secure the electrical insulation between the connecting portions 13A and 15A. However, if the first sealing film 17A is formed by a multi-layer film and the metallic film is formed on or over the first layer of the multi-layer film, the metallic film does not interfere with the electrical insulation. Because under the condition of the same film thickness the metallic film is harder to cause a pinhole than a ceramic film and higher in shock resistance than the ceramic film, the performance of the sealing film 17 is improved.

When the first sealing film 17A is formed by the dry process, the dry process is not limited to the plasma CVD process, but may be another process for forming a thin film under a vacuum state or reduced pressure. The dry process may be another CVD process, a vacuum deposition process, a sputtering process, an ion plating process and a process using ion beam.

The first sealing film 17A is not limited to the film made of inorganic material (material of inorganic system), but may be a film made of organic material (material of organic system) which is low in moisture permeability. The organic material includes epoxy resin, polyethylene naphthalate (PEN), polyethylene terephthalate (PET), polystylene and acrylic (acrylic resin). The film formed by the organic material is not limited to a single-layer film, but may be a multi-layer film in which films made of different materials are laminated. Alternatively, the film formed by the organic material may be a composite film formed by a combination of different materials.

The first sealing film 17A may be a laminated film of the film formed by the inorganic material and the film formed by the organic material. The first sealing film 17A may also be a composite film, in which a combination of the inorganic material and the organic material is deposited.

In the above embodiment, the second sealing film 17B is formed so as to cover the first sealing film 17A. In a modification of the embodiment, however, the second sealing film 17B formed by the wet process is in contact with the second electrode 15 and the first sealing film 17A formed by the dry process is laminated on the second sealing film 17B. That is, the dry process is performed after the wet process.

In the above embodiment, when the second sealing film 17B is formed by the wet process, the solution of the material of the second sealing film 17B is applied by the spray coating. In modifications of the embodiment, however, the solution of the material of the second sealing film 17B is applied by a slit coating, a spin coating or a dip coating.

The sealing film 17 may be formed only by a film formed by the wet process. For example, the sealing film 17 may be formed only by the first sealing film 17A formed from polysilazane solution.

When the sealing film 17 is formed only by the wet process, the coating film may be laminated in addition to the second sealing film 17B formed from polysilazane. The coating film is formed by another material which is low in moisture and oxygen permeability. The coating film may be formed by a resin which is low in moisture permeability. The resin includes epoxy resin, polyethylene naphthalate (PEN), polyethylene terephthalate (PET), polystylene and acrylic (acrylic resin).

The sealing film 17 may include an organic film formed under the first sealing film 17A for providing a lamination plane of the sealing film 17 with evenness.

The organic EL device 11 is not limited to the bottom emission type wherein the light is extracted through the glass substrate 12, but may be a top emission type wherein the light is extracted through the sealing film 17.

The substrate which forms a part of the organic device of the present invention is not limited to the glass substrate. As long as the substrate of the organic device is a brittle substrate, material of the substrate may be silicon. In the present invention, the brittle substrate is a substrate which makes it possible to be scribed and broken.

The organic device of the present invention is not limited to the organic EL device 11. It is only necessary that the organic element formed on the substrate is sealed by the sealing film so as to exclude at least a part of each connecting portion. For example, the organic element such as an organic transistor, an organic diode and the like may be formed on the substrate to form a part of a circuit.

Although in the present embodiment the organic EL element 16 is provided with two connecting portions, the organic EL element 16 may be provided with only one connecting portion. Alternatively, the organic EL element 16 may be provided with three or more connecting portions.

The organic device of the present invention may be formed so that an element on the substrate includes material of organic system. However, the organic device may be formed so that the element on the substrate includes material of inorganic system and a complex of the material of organic system and the material of inorganic system. The element may serve as an electric and electronic element such as a light power generation, a light sensor, an arithmetic circuit and the like. A single electric and electronic element, or a complex of electric and electronic elements may be used for the organic device.

The organic device of the present invention is not necessarily formed so that only the organic element formed on the substrate is sealed by the sealing film 17. The organic device may be a display in which a drive circuit made of organic material and inorganic material is mounted on the substrate. For example, the organic EL element emitted by the organic transistor is formed with the drive circuit made of low-temperature polysilicon on the same substrate.

In the above embodiment, nine organic EL elements 16 are formed in the form of a 3 x 3 matrix on the large-size glass substrate 1. However, the number of the organic EL elements 16 formed on the large-size glass substrate 1 and the form of the organic EL elements 16 are not limited to the above embodiment. It is only necessary that a plurality of organic EL elements 16 are formed in the form of a matrix on the large-size glass substrate 1.

Therefore, the present examples and embodiments are to be considered as illustrative and not restrictive, and the invention is not to be limited to the details given herein but may be modified within the scope of the appended claims.

A method of manufacturing an organic device includes the following steps. The first step is a step of forming a plurality of organic elements in the form of a matrix on a brittle substrate. Each of the organic elements is provided with an electrically connecting portion which electrically connects the organic element to an external circuit. The second step is a step of forming a sealing film on each organic element by a wet process with at least a part of the connecting portion covered with an adhesive masking material. The third step is a step of removing an adhesive deposit after peeling off the adhesive masking material. The fourth step is a step of forming a plurality of scribe lines on the brittle substrate. The fifth step is a step of breaking the brittle substrate along the scribe lines.

## Claims

1. A method of manufacturing an organic device (11), wherein a plurality of organic elements (16) are formed on a brittle substrate (1) and each organic element (16) is provided with an electrically connecting portion (13A, 15A) which electrically connects the organic element (16) to an external circuit, wherein the organic element (16) is sealed by a sealing film (17) so as to exclude at least a part of the connecting portion (13A, 15A), the method being **characterized by**:
forming the organic elements (16) in the form of a matrix on the brittle substrate (1);
forming the sealing film (17B) on each organic element (16) by a wet process with at least a part of the connecting portion (13A, 15A) covered with an adhesive masking material (18);
removing an adhesive deposit (19) (18) after peeling off the adhesive masking material (18);
forming a plurality of scribe lines (22) on the brittle substrate (1); and
breaking the brittle substrate (1) along the scribe lines (22).

2. The method according to claim 1, **characterized in that** the step (S4) of forming the sealing film with the wet process is performed after a step (S3) of forming a sealing film with a dry process.

3. The method according to claim 2, **characterized in that** a sealing film (17A) formed in the step (S3) of forming the sealing film with the dry process is made of silicon nitride.

4. The method according to any one of claims 1 through 3, **characterized in that** the step (S5) of removing the adhesive deposit includes a process of polishing the connecting portion (13A, 15A).

5. The method according to claim 4, **characterized in that** the polishing of the connecting portion (13A, 15A) is buffing.

6. The method according to claim 5, wherein diamond paste is used for the buffing.

7. The method according to any one of claims 1 through 5, **characterized in that** each organic element (16) is an organic electroluminescence element.

8. The method according to any one of claims 1 through 7, **characterized in that** the sealing film (17B) formed in the step (S4) of forming the sealing film with the wet process is formed from coating film of polysilazane.

9. The method according to any one of claims 1 through 8, **characterized in that** the adhesive masking material (18) is a masking tape.
